(19) Europäisches Patentamt
European Patent Office
Office européen des brevets

(11) **EP 3 499 278 A1**

(12) **EUROPEAN PATENT APPLICATION**

(43) Date of publication:
**19.06.2019 Bulletin 2019/25**

(51) Int Cl.:
*G02B 5/18* (2006.01)          *G02B 6/34* (2006.01)
*F21V 8/00* (2006.01)          *G02B 6/124* (2006.01)

(21) Application number: **17306763.8**

(22) Date of filing: **13.12.2017**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD TN**

(71) Applicant: **THOMSON LICENSING
92130 Issy les Moulineaux (FR)**

(72) Inventors:
• **DAMGHANIAN, Mitra
35576 CESSON-SEVIGNE (FR)**
• **SHRAMKOVA, Oksana
35576 CESSON-SEVIGNE (FR)**
• **DRAZIC, Valter
35576 CESSON-SEVIGNE (FR)**

(74) Representative: **Vidon Brevets & Stratégie
16B, rue de Jouanet
BP 90333
35703 Rennes Cedex 7 (FR)**

(54) **A DIFFRACTION GRATING STRUCTURE COMPRISING SEVERAL GRATING LINES**

(57)     In one embodiment of the disclosure, it is proposed diffraction grating structure comprising several grating lines. The diffraction grating structure is associated with a propagation layer, and the diffraction grating structure is made of a material that has a refractive index being equal to $n_2(\lambda)$. The diffraction grating structure is remarkable in that it comprises $1/T$ grating lines per $\mu$m, with $T = (n_2(\lambda) + 1)/\lambda$, where $\lambda$ is a wavelength defined from an incident electromagnetic wave.

Figure 1

**Description**

Technical Field

The disclosure relates to a technique for enhancing the field of view associated with a diffraction grating structure.

Background

This section is intended to introduce the reader to various aspects of art, which may be related to various aspects of the present invention that are described and/or claimed below. This discussion is believed to be helpful in providing the reader with background information to facilitate a better understanding of the various aspects of the present invention. Accordingly, it should be understood that these statements are to be read in this light, and not as admissions of prior art. More precisely, in the following, the context of augmented reality glasses will be discussed. However, the present technique can also be applied to a solar cell for harvesting energy or also to an OLED (which stands for Organic Light-Emitting Diode) cell (that is part of an OLED display device).

Augmented reality glasses (AR) or see through glasses or near-eyes display glasses enable a user to mix added information or virtual data with the real world.

Therefore, a user that wears such kind of device enjoys new experiment, and it provides a way to enhance the real world that surrounds us. In order to achieve such effect, one solution consists in having a system with an augmented reality glasses (AR) that comprises a picture generation unit (that can generate image angular content or virtual image that is an afocal image) associated with a given field of view, a light source unit for generating a light representation of the picture, an input grating and an optical waveguide, an horizontal eye box magnification, a vertical eye box magnification, and an output grating for delivering the light representation of the picture to the eye box of the user.

The function of the input grating is to receive the biggest possible field of view (FoV) and to deviate the light coming from the light source within the optical waveguide in such way the light is guided inside by total internal reflection (TIR) without the degradation of the virtual image.

Examples of augmented reality glasses (AR) are depicted in documents WO2017180403, US2012127577, US9019615 and US 20090128911.

However, common input grating design suffers from limitation on the size of possible field of views. Even if techniques have been developed for extending the size of possible field of views (see for example document WO 2017180403), the obtained results are still not satisfying for the users. The proposed technique tries to overcome these limitations.

Summary of the disclosure

References in the specification to "one embodiment", "an embodiment", "an example embodiment", indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described.

In one embodiment of the disclosure, it is proposed a diffraction grating structure comprising several grating lines. The diffraction grating structure is associated with a propagation layer, and the diffraction grating structure is made of a material that has a refractive index which is equal to $n_2(\lambda)$. The diffraction grating structure is remarkable in that it comprises $1/T$ grating lines per $\mu m$, with $T = (n_2(\lambda) + 1)/\lambda$, where $\lambda$ is a wavelength defined from an incident electromagnetic wave.

Indeed, $\lambda$ is defined as a function of an incident electromagnetic wave. In one embodiment of the disclosure, when the incident electromagnetic wave is polychromatic, the value of $\lambda$ used for defining $T$ is obtained from the different wavelengths of an incident electromagnetic wave. In another embodiment, when the incident electromagnetic wave is monochromatic, the value of $\lambda$ used for defining $T$ is obtained directly from the wavelength of the incident electromagnetic wave.

In a preferred embodiment, the refractive index $n_2(\lambda)$ is comprised between 1.54 and 1.51 when a wavelength of an incident electromagnetic wave is belonging to a range of 400 nm-800 nm.

In a preferred embodiment, the wavelength of an incident electromagnetic wave is around 486 nm. Indeed, the wavelength of an incident electromagnetic wave is associated with the blue color.

In a preferred embodiment, the wavelength of an incident electromagnetic wave is around 588 nm. Indeed, the wavelength of an incident electromagnetic wave is associated with the green color.

In a preferred embodiment, the wavelength of an incident electromagnetic wave is around 656 nm. Indeed, the wavelength of an incident electromagnetic wave is associated with the red color.

In a preferred embodiment, the propagation layer and the diffraction grating structure have a same refractive index.

In a preferred embodiment, the propagation layer and the diffraction grating structure have different refractive indexes.

In a preferred embodiment, it is proposed an optical device comprising a light emitting source that can emit electromagnetic waves that correspond to at least one of the three primary colors among the red, blue and green colors, and an optical waveguide for guiding light emitted by said light emitting source. The optical device further comprises a diffraction grating structure intended to received light, from a specific color, as previously mentioned.

In a preferred embodiment, the optical device further comprises at least another diffraction grating structure comprising several grating lines. Such another diffraction grating is positioned on the diffraction grating, and the at least another diffraction grating is made of a material having a refractive index being equal to $n_3(\lambda)$. Such another diffraction grating is remarkable in that it comprises 1/T grating lines per $\mu m$, with $T = (n_3(\lambda) + 1)/\lambda$.

In a preferred embodiment, each incident electromagnetic wave is normal compared to diffraction grating structures comprised in said optical device.

In a preferred embodiment, the grating lines of the diffraction grating structure define a rectangle with a length of 1 to 10 mm, and a width of 1 a 10 mm.

In a variant, it is proposed an OLED cell, comprising an anode positioned on a glass substrate, a cathode, and between the anode and the cathode respectively an electron transport layer, a light emitting material, and a hole transport layer, the light emitting material being associated with a light color. The OLED cell comprises a diffraction grating structure positioned on said glass substrate and the wavelength of the incident electromagnetic wave corresponds to the one associated with said light color.

In a preferred embodiment, the grating lines of the diffraction grating structure define a surface that covers 50 % of the glass substrate of the OLED cell.

In a variant, it is proposed a solar cell comprising a diffraction grating structure as mentioned previously. In addition, $\lambda$ is chosen as being equal to 588 nm and the incident electromagnetic wave corresponds to light coming from the sun.

In a preferred embodiment of the disclosure, the grating lines covers all the surface of the solar cell.

Brief description of the drawings

The above and other aspects of the invention will become more apparent by the following detailed description of exemplary embodiments thereof with reference to the attached drawings in which:

- **Figure 1** presents an example of a diffraction process performed by a diffraction grating structure as known in the prior art;
- **Figure 2** presents an example of a diffraction process performed by a diffraction grating structure according to one embodiment of the disclosure;
- **Figure 3** presents the correlation or relationship that links the index of refraction of a propagation layer and the field of view when using a diffraction grating according to one embodiment of the disclosure;
- **Figure 4** presents the relationship between the index of refraction of a glass material and an incident electromagnetic wave;
- **Figure 5** presents the relationship between the index of refraction of silicon material and an incident electromagnetic wave.

Detailed description

According to one embodiment of the disclosure, it is proposed a diffractive grating structure that comprises a linear array of sub-wavelength structures to diffract the light that comes from either a light source device (as for example the light sources in documents WO 2017180403, US2012127577, US9019615 and US20090128911) or from another source of light (such as the sun for example). It should be noted that the light source device can emit either monochromatic light or polychromatic light according to the intended use or goal.

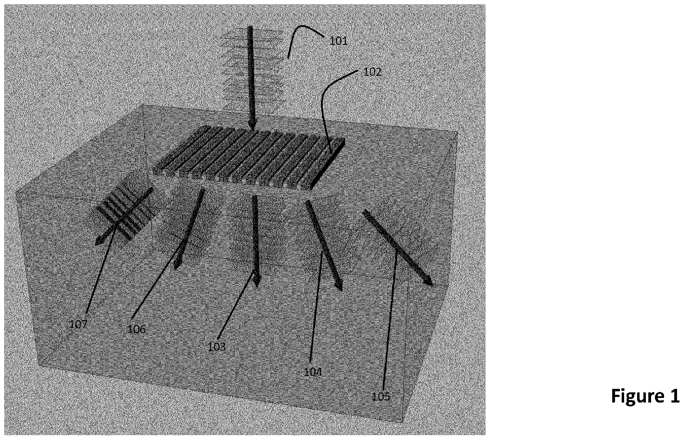

In order to describe the present disclosure, it is proposed to remind the reader with the diffractive process that one can observe in presence with a conventional diffractive grating structure (as the one mentioned in the previously mentioned documents WO 2017180403, US2012127577, US9019615 and US 20090128911). The Figure 1 shows schematically what happens when a plane electromagnetic wave referenced 101 hits a diffractive grating structure referenced 102 that comprises a set of lines or slabs or slits. The diffractive grating structure 102 is positioned on a propagation layer. Due to the presence of the lines, the incident electromagnetic wave 101 is divided into diffraction modes, which are angular spaced beams of local maximum intensity. In the figure 1, the five diffracted modes number are represented (respectively the diffraction mode -2 (referenced as 107 in Figure 1), the diffraction mode -1 (referenced as 106 in the Figure 1), the diffraction mode 0 (referenced as 103 in the Figure 1), the diffraction mode 1 (referenced as 104 in the Figure 1), and the diffraction mode 2 (referenced as 105 in the Figure 1). Obviously, other higher or smaller orders exist, but they are not represented in the Figure 1 in order to ease the understanding of the content of Figure 1. More details concerning a diffraction grating structure can be obtained in the section 5.6 of the document entitled *"Diffraction, Fourier Optics and Imaging"* by Okan K. Ersoy, published by John Wiley & Sons.

The order zero 103 has in general the more power and is the natural mode into which the regular refraction or reflection would occur. In general, a diffraction grating structure generates a lot of diffraction orders. In numerous applications it is wishful to suppress or cancel all other modes but the first one.

Hence, there is a need to provide a diffraction grating structure that can heavily privilege the first diffraction order and reduce (or suppress) as much as possible the other diffraction orders.

We focus hereafter the coupling into a wave guide of the first diffraction order. In fact, all diffraction orders are linked to the incoming electromagnetic wave by the following equation (referenced as equation (1)):

$$n_2(\lambda)\sin\theta_2 - n_1(\lambda)\sin\theta_1 = M.\lambda.T$$

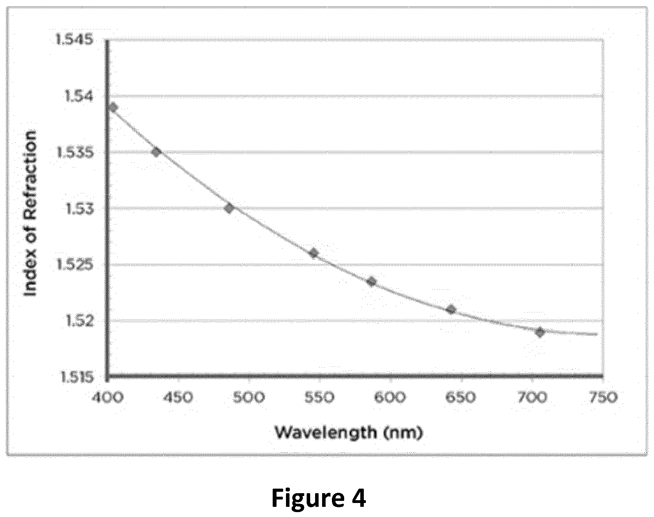

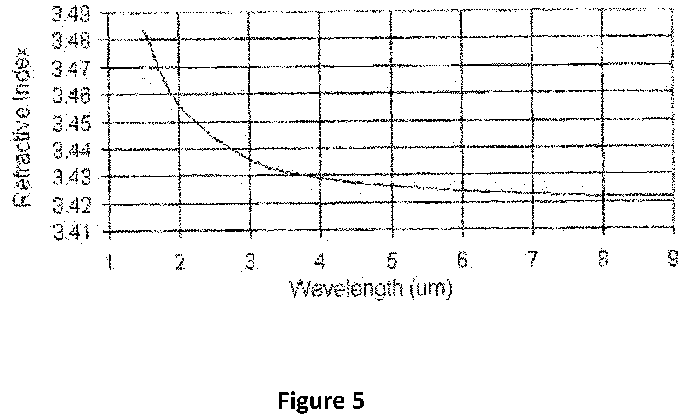

where $n_1(\lambda)$ and $n_2(\lambda)$ are respectively the index of refraction of the incident layer/media and the index of refraction of the diffracted layer/media (also named the propagation layer). It should be noted that the refractive index of a material is wavelength dependent. For example, the refractive index of a glass increases as the wavelength of incident light gets shorter (see figure 4). The same remark can be done for silicon material (see figure 5). In most case $n_1(\lambda) = 1$. The following notations are also used: $\theta_1$ is the incident angle, $\theta_2$ the diffracted angle, $M$ is the diffraction order, $\lambda$ the wavelength and $T$ the grating frequency, which is expressed in lines per $\mu m$ if the wavelength is also expressed in $\mu m$.

Therefore, for the zero-diffraction order (i.e. $M = 0$), the equation (1) is reduced to the well-known Snell-Descartes's law of refraction.

One can notice that the diffraction process is very dispersive. The refraction is different for different wavelength as the index is frequency dependent, but the diffraction varies linearly with the wavelength ($M\lambda T$) which is quite a big variation. It is therefore necessary to find a mean to minimize chromatic aberrations. One way, but not the preferred one, is to design the wave guide as part of the light source device and balance that chromatic aberration with different set of glasses in the projection lens.

For that purpose, the wavelength used to correct this aberration are the Fraunhofer *F, d, C* spectral lines which are used to optimize the glass constringences in the glass substitution method to minimize lateral and longitudinal chroma: (*F, d, C*) = (0,486; 0.588; 0.656) $\mu m$.

More details concerning the Fraunhofer spectral lines are given in the document entitled *"Spectroscopy for Amateur Astronomers: Recording, Processing, Analysis and Interpretation"* by Marc F. M. Tristen and Richard Walker.

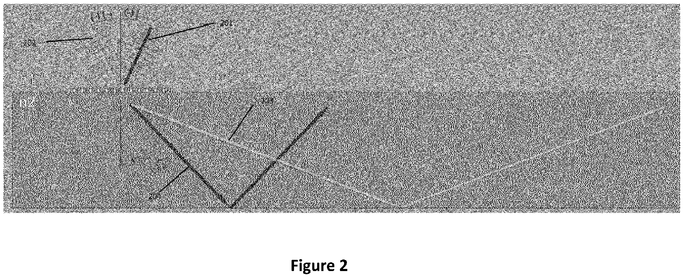

All notations being set, we can calculate now the Field of View (FoV) of a waveguide. Indeed, the field of view is defined as the difference between the limit incident angles for the incoming electromagnetic waves that can be propagated into the wave guide. Therefore, in view of the Figure 2, it appears that the field of view is defined by the value $\theta_1^+ - \theta_1^-$, where the values $\theta_1^-$ and $\theta_1^+$ corresponds respectively to the limit incident angles for the incoming electromagnetic waves that can propagate into the wave guide. Indeed, if an incident electromagnetic wave hits a diffraction structure with a given angle that is not comprised in the interval $[\theta_1^+; \theta_1^-]$, then no propagation of the incident electromagnetic wave occurs. However, if an incident electromagnetic wave hits a diffraction structure with a given angle that is comprised in the interval $[\theta_1^+; \theta_1^-]$, then a propagation of the incident electromagnetic wave occurs. For example, in the figure 2, the incident electromagnetic wave referenced 202 that hits the diffraction grating structure with a limit angle $\theta_1^+$, is propagated in the propagation layer according to total internal reflection according to the path referenced 203. In the same way, the incident electromagnetic wave referenced 201 that hits the diffraction grating structure with a limit angle $\theta_1^-$, is propagated in the propagation layer according to total internal reflection according to the path referenced 204.

The critical angle $\theta_{2c}$ (being equal to either $\theta_1^+$ or $\theta_1^-$, is defined by the following equation (referenced as equation 2):

$$\sin\theta_{2c} = \frac{1}{n_2(\lambda)}$$

and replacing the $\theta_{2c}$ value from equation 1 with this one leads then to the lowest possible in coupling angle that still traps the first diffraction order (equation referenced as equation (3)):

$$\theta_1^- \geq sin^{-1}(1 - \lambda T)$$

which is a very remarkable result. Indeed, it can be noted that the lowest possible value for enabling a propagation into the propagation layer is not dependent on the index of refraction $n_2$ of the material of the propagation layer. Of course, it is supposed that $n_1 = 1$. In the following, it is proposed to determine the highest possible angle value (i.e. the coupling angle $\theta_1^+$). It can be noted that (in the equation referenced as equation (4)):

$$\sin \theta_{2c} = \frac{\lambda T + \sin \theta_1^+}{n_2(\lambda)} \leq 1$$

Which is equivalent to $\theta_1^+ \leq sin^{-1}(n_2(\lambda) - \lambda T)$.

Hence, finally, in order to be propagate into the propagation layer, an incident electromagnetic wave must have an incident angle $\theta_1$ that must fulfill the following conditions:

$$sin^{-1}(1 - \lambda T) \leq \theta_1 \leq sin^{-1}(n_2(\lambda) - \lambda T).$$

Before deriving an expression for the total field of view, it shall be taken into account that in the case of the use of a light source device, the field of view is a symmetric field of view, and an exit pupil which is angularly equally filled, so that the extreme values should obey the relationship $\theta_1^+ = -\theta_1^-$, and if we set that equations 3 and 4 have opposite values, then we get the value of the diffraction grating's frequency (equation referenced as equation (6)):

$$T = (n_2(\lambda) + 1)/2\lambda$$

In order to have some values in mind, the grating frequencies for a dispersion less waveguide of index 1.5 are: (B(0:486); G(0:588); R(0:656)) = (2:57; 2:13; 1:91) lines=$\mu$m.

The fact that they are so different suggests strongly to use a specific grating for each of the primaries. It is going to be very difficult, due to the strong dispersion by diffraction to handle the whole visible range with a unique waveguide.

The field of view is equal to $\Delta\theta_1 = sin^{-1}(n_2(\lambda) - \lambda T) + sin^{-1}(1 - \lambda T)$ after introducing the expression for $T$ as defined in equation (6).

Hence, we have a field of view which is equal to $\Delta\theta_1 = 2sin^{-1}\left(\frac{n_2(\lambda)-1}{2}\right).$ Such equation is referenced as equation (7) in the following.

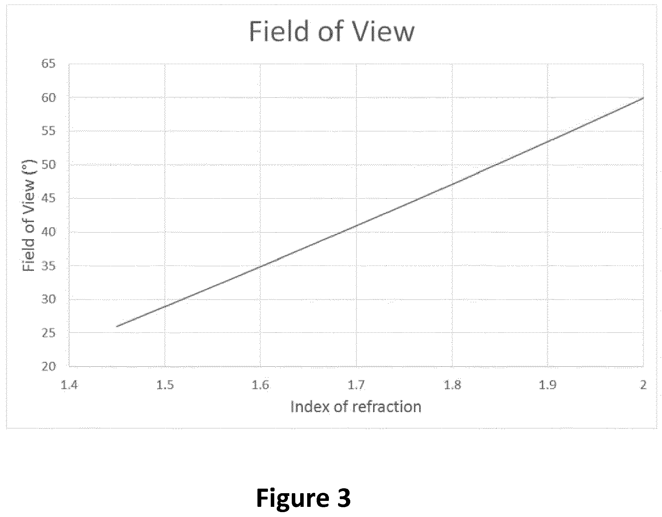

Figure 3 shows a graph for some examples of ranges of $n_2$. For $n_2 = 1.5$, the total field of view is rather limited to $\Delta\theta_1 = 28.96$ degrees. In order to get to a field of view of 40 degrees, like the Wave Optics guide, it is preferable to use a material with $n_2 = 1.684$ for the d spectral line.

In fact, there are optical glasses with very interesting characteristics for such an application, whose cost is comparable to BK7, for instance the glass LASF35 from Schott's catalog has an index of (2.046/F, 2.023/d, 2.012C) and gets a field of view a little bit above 60 degrees diagonal, which shows the very strong dependence of the FoV on the material of the waveguide. Of course, for the LASF35 glass, the grating frequencies need to be matched to the index and we would need to use $T = (3.11(F), 2.57(d), 2.30(C))$ lines per $\mu m$.

It should also be noted that a field of view having a value of 60 degrees should be considered as the limit for flat wave guides because there are no other materials of refractive index above 2.0 for the moment.

In addition, it should be noted that the total field of view, as defined in equation (7) does not depend on the wavelength (except for the refractive index, but such link has a small impact in term of variations). This is an interesting observation because this means that, although the diffraction orders angular spectrum strongly varies with the wavelength, the field of view for one order (here the first order) only depends on the index of refraction, which is the normal dependence in lens design tasks and could be balanced out by a join design with the main lens of the light engine.

In another embodiment of the disclosure, it is proposed to use the previously mentioned diffraction grating in a solar cell.

Reminders on Solar cell are provided in the section 6.15 and 6.16 of the book entitled _"Principles of Solar cells, LEDs and Diodes; The role of the PN junction"_ by Adrian Kitai. Indeed, a solar cell can be made of an anode positioned on a glass substrate, a cathode, and between the anode and the cathode, an organic semiconductor. The anode is usually a transparent anode (for example the anode is made of indium tin oxide (ITO)). Such kind of solar cell is mentioned as a single-layer organic solar cell.

In a variant, a solar cell can be made of an anode positioned on a glass substrate, a cathode, and between the anode and the cathode, a bulk heterojunction. The anode is usually a transparent anode (for example the anode is made of indium tin oxide (ITO)).

The previous developments concerning the field of views can be applied to solar cells.

It can be noted that equation (7) leads to a maximum field of view of 180 for $n_2 \geq 3$. The various form of Silicon used in solar cell, mono-crystalline, polycristalline or amorphous, have all values above 3. This means that if we provide the solar cell with such a diffraction grating structure, it will couple all incoming light, whatever the angle, coming from the full half hemisphere, into a guided mode inside the silicon.

The very practical application is that we can then reduce the solar cell thickness to some wavelength (10 $\mu m$ thick for instance) and the light will still be absorbed because it will bounce into the material until total absorption, whatever the angle of incidence!

As we can suppress or attenuate all other orders but the first one with the diffraction grating structure according to one embodiment of the disclosure, there is a potential for exploiting a low cost fabrication of highly efficient and very thin solar cells. The price and fabrication delay of solar cell seem to be very correlated to their thickness, so that adding the cost of a diffraction grating structure might be of interest.

Once the whole surface of a solar cell gets covered by a diffraction grating structure according to one embodiment of the disclosure, it can be interesting to detail what happens to light that hits the grating from the inside. It has been observed the following when playing around with diffraction grating structures in Zemax if the diffraction grating structure is not optimized to diffract only order 1:

- **Order zero**: The order zero does go through the wave guide by definition. It can never be trapped inside. This is the reason it should be highly minimized by the structure producing the diffraction;
- **Order 1:** The first order gets totally coupled in for a 180 degrees FoV for $n_2 \geq 3.0$ and for the grating frequency given by equation (6) for the particular wavelength;
- **Multiple diffraction of trapped light:** The light trapped into the propagation layer or wave guide can hit the diffraction structure from inside and produce multiple diffraction orders (also named secondary diffraction). All secondary diffraction orders do stay into the propagation layer or waveguide; only the order -1 will get extracted out of the propagation layer which might be considered a small loss;
- **Order 2:** Order 2 gets reflected away for $\theta_1 \geq 0$ and coupled in for negative angles;
- **Order 3 and above:** Never get into the waveguide, they are reflected away by the grating;
- **Order -1:** The same as for the order one, but the waves will propagate into the opposite direction into the waveguide;
- **Order -2:** Same as for order 2, but the angles that get coupled in are $\theta_1 > 0$;
- **Order -3 and less:** They don't get into the waveguide.

As a conclusion, if we have a diffraction grating which mostly generates order 1, all light will get coupled into the propagation layer or waveguide. Once into the waveguide, it won't be extracted out even if it hits the diffraction structure from inside. This makes that technology more than suited to ultra-thin solar cells made of any form of silicon.

In a variant, the solar cell comprises a diffraction grating structure that has a frequency of lines that is defined according to a wavelength comprised in the range 495-570 nm (i.e. corresponding to the green). Indeed, as the light coming from the sun is not a monochromatic electromagnetic wave, it is more interesting to use a diffraction grating structure designed for privileging the "green" electromagnetic waves as the radiate energy from incident light received from the sun on Earth is dominated by wavelengths comprised in the range 495-570 nm.

In another embodiment of the disclosure, it is proposed to use the previously mentioned diffraction grating within an OLED cell.

Reminders on OLED cell are provided in the Chapter 6 of the book entitled *"Principles of Solar cells, LEDs and Diodes; The role of the PN junction"* by Adrian Kitai.

To sum-up, usually, an OLED cell comprises an anode positioned on a glass substrate, a cathode, and between the anode and the cathode, active layers that comprise an electron transport layer (ETL) and a hole transport layer (HTL). Generally, the anode is made of a transparent material in order to allow light to leave active layers. For example, the anode can be made of an indium tin oxide (ITO). In a variant, a light emitting material (LEM) can also be positioned between the HTL and the ETL. It should be noted that the color emitted by an OLED is determined or linked by the nature of the LEM. Hence, it is possible to choose specific material of the LEM in order to obtain an OLED cell that only delivers monochromatic electromagnetic wave (i.e. monochromatic light). Therefore, the proposed diffraction grating is positioned to receive the lights or electromagnetic waves and then to favor or privilege the first diffraction order waves resulting from the diffraction process linked to the structure of the diffraction grating according to one embodiment of the disclosure.

Usually, in OLED cells, there is only a small portion of light that gets out of the cell. Because the light has been generated into a much denser media than air, the biggest amount is trapped into the structure by total internal reflection phenomenon. In the previous section, it has been explained that trapped light can get totally extracted if it hits a diffraction grating which is optimized for the order -1.

In fact, it seems that on both sides of the barrier between the air and dense media, if diffracted order 1 gets trapped into the structure, the diffraction order -1 gets extracted. Hence, order 1 and -1 do play complementary roles on both sides of the grating.

In order to achieve an efficient extraction, it is used a so called thick grating, whose thickness can have 10 $\mu m$. This kind of extraction device is only interesting if the lateral cell structures are pixels of much larger size.

Hence, if thin diffraction gratings are used, only the order -1 is extracted at each bouncing on the grating.

Still, by recurrent round trips of the light into the OLED cell, there will be significantly more light extracted by the grating, even if it is not optimized for order -1.

In one embodiment of the disclosure, it is proposed to use a diffraction grating structure, with $n_1$ = 1, $n_2$ = 1.7 that comprises different parts comprising respectively grating lines having the following frequencies: 2.78, 2.30 and 2.06 lines per $\mu m$, and these different parts are intended to receive respectively only one kind of electromagnetic waves having the following wavelengths: 0.486, 0.588 and 0.656 $\mu m$. In such embodiment, the field of view is of about 41 degrees so the plane waves with incidence angles of -20,-10,0,10 and 20 degrees can be used. We can assume as a starting point that the material is non-dispersive.

In another embodiment of the disclosure, it is proposed to use diffraction grating structure, with $n_1$ = 1, $n_2$ = 2.0 that comprises different parts comprising respectively grating lines having the following frequencies: 3.09, 2.55 and 2.29 lines per $\mu m$, and these different parts are intended to receive respectively only one kind of electromagnetic waves having the following wavelengths: 0.486, 0.588 and 0.656 $\mu m$. In such embodiment, the field of view is of about 60 degrees so the plane waves with incidence angles of -30,-20, -10,0,10, 20 and 30 degrees can be used. We can assume as a starting point that the material is non-dispersive.

In another embodiment of the disclosure, it is proposed to superpose the diffractive grating structures.

## Claims

1.  A diffraction grating structure comprising several grating lines, said diffraction grating structure being associated with a propagation layer, said diffraction grating structure being made of a material that has a refractive index being equal to $n_2(\lambda)$, the diffraction grating structure being **characterized in that** it comprises $1/T$ grating lines per $\mu m$, with $T = (n_2(\lambda) + 1)/\lambda$, where $\lambda$ is a wavelength defined from an incident electromagnetic wave.

2.  The diffraction grating according to claim 1, wherein the refractive index $n_2(\lambda)$ is comprised between 1.54 and 1.51 when a wavelength of an incident electromagnetic wave is belonging to a range of 400 nm-800 nm.

3.  The diffraction grating according to claim 1, wherein said material is silicon.

4.  The diffraction grating according to any claims 1 to 3, wherein a wavelength of the incident electromagnetic wave is around 486 nm.

5.  The diffraction grating according to any claims 1 to 3, wherein a wavelength of the incident electromagnetic wave is around 588 nm.

6.  The diffraction grating according to any claims 1 to 3, wherein a wavelength of the incident electromagnetic wave is around 656 nm.

7.  The diffraction grating according to any claims 1 to 6, wherein said propagation layer and said diffraction grating structure have a same refractive index.

8.  The diffraction grating according to any claims 1 to 6, wherein said propagation layer and said diffraction grating structure have different refractive indexes.

9.  An optical device comprising a light emitting source that can emit electromagnetic waves that correspond to at least one of the three primary colors among the red, blue and green colors, and an optical waveguide for guiding light emitted by said light emitting source, wherein said optical device further comprises a diffraction grating structure intended to received light, from a specific color, according to claim 1.

10. The optical device according to claim 9, wherein it further comprises at least another diffraction grating structure comprising several grating lines, said another diffraction grating being positioned on said diffraction grating, said at least another diffraction grating being made of a material having a refractive index being equal to $n_3(\lambda)$, said another diffraction grating being **characterized in that** it comprises 1/T grating lines per $\mu m$, with $T = (n_3(\lambda) + 1)/\lambda$.

11. The optical device according to any claims 9 to 10, wherein each incident electromagnetic wave is normal compared to diffraction grating structures comprised in said optical device.

12. The optical device according to any claims 9 to 11, wherein the grating lines of said diffraction grating structure define a rectangle with a length of 1 to 10 mm, and a width of 1 à 10 mm.

13. An OLED cell, comprising an anode positioned on a glass substrate, a cathode, and between the anode and the cathode respectively an electron transport layer, a light emitting material, and a hole transport layer, the light emitting material being associated with a light color, wherein said OLED cell comprises a diffraction grating structure positioned on said glass substrate according to claim 1, wherein the wavelength of the incident electromagnetic wave corresponds to the one associated with said light color.

14. The OLED cell according to claim 13, wherein the grating lines of said diffraction grating structure define a surface that covers 50 % of said glass substrate of said OLED cell.

15. A solar cell comprising a diffraction grating structure according to claim 1, wherein $\lambda$ is chosen as being equal to 588 nm and the incident electromagnetic wave being light coming from the sun.

**Amended claims in accordance with Rule 137(2) EPC.**

1. A diffraction grating structure (102) comprising several grating lines, said diffraction grating structure being associated with a propagation layer and made of a material that has a refractive index being equal to $n_2(\lambda)$, the diffraction grating structure being **characterized in that** said grating lines are defined by a grating frequency $T$ such as:

$$T = (n_2(\lambda) + 1)/\lambda$$

where $\lambda$ is a wavelength of an incident electromagnetic wave.

2. The diffraction grating structure (102) according to claim 1, wherein the refractive index $n_2(\lambda)$ is comprised between 1.54 and 1.51 when a wavelength of an incident electromagnetic wave is belonging to a range of 400 nm-800 nm.

3. The diffraction grating structure (102) according to claim 1, wherein said material is silicon.

4. The diffraction grating structure (102) according to any claims 1 to 3, wherein a wavelength of the incident electromagnetic wave is around 486 nm.

5. The diffraction grating structure (102) according to any claims 1 to 3, wherein a wavelength of the incident electromagnetic wave is around 588 nm.

6. The diffraction grating structure (102) according to any claims 1 to 3, wherein a wavelength of the incident electromagnetic wave is around 656 nm.

7. The diffraction grating structure (102) according to any claims 1 to 6, wherein said propagation layer and said diffraction grating structure have a same refractive index.

8. The diffraction grating structure (102) according to any claims 1 to 6, wherein said propagation layer and said diffraction grating structure have different refractive indexes.

9. An optical device comprising a light emitting source that can emit electromagnetic waves that correspond to at least one of the three primary colors among the red, blue and green colors, and an optical waveguide for guiding light emitted by said light emitting source, wherein said optical device further comprises a diffraction grating structure (102) intended to received light, from a specific color, according to claim 1.

10. The optical device according to claim 9, wherein it further comprises at least another diffraction grating structure comprising several another grating lines, said another diffraction grating structure being positioned on said diffraction grating structure, said at least another diffraction grating being made of a material having a refractive index being equal to $n_3(\lambda)$, said another diffraction grating being **characterized in that** said another grating lines are defined by a grating frequency $T$ such as:

$$T = (n_3(\lambda) + 1)/\lambda.$$

11. The optical device according to any claims 9 to 10, wherein each incident electromagnetic wave is normal compared to diffraction grating structures comprised in said optical device.

12. The optical device according to any claims 9 to 11, wherein the grating lines of said diffraction grating structure define a rectangle with a length of 1 to 10 mm, and a width of 1 a 10 mm.

13. An OLED cell, comprising an anode positioned on a glass substrate, a cathode, and between the anode and the cathode respectively an electron transport layer, a light emitting material, and a hole transport layer, the light emitting material being associated with a light color, wherein said OLED cell comprises a diffraction grating structure (102) positioned on said glass substrate according to claim 1, wherein the wavelength of the incident electromagnetic wave corresponds to the one associated with said light color.

14. The OLED cell according to claim 13, wherein the grating lines of said diffraction grating structure define a surface that covers 50 % of said glass substrate of said OLED cell.

15. A solar cell comprising a diffraction grating structure according to claim 1, wherein $\lambda$ is chosen as being equal to 588 nm and the incident electromagnetic wave being light coming from the sun.

Figure 1

**Figure 2**

**Figure 3**

**Figure 4**

**Figure 5**

Europäisches
Patentamt

European
Patent Office

Office européen
des brevets

## EUROPEAN SEARCH REPORT

Application Number

EP 17 30 6763

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 9 442 227 B2 (PESALA BALA [IN]; COUNCIL SCIENT IND RES [IN]) 13 September 2016 (2016-09-13) * the whole document * ----- | 1,3,8,15 | INV. G02B5/18 G02B6/34 F21V8/00 G02B6/124 |
| X | US 2008/043334 A1 (ITZKOVITCH MOTI [IL] ET AL) 21 February 2008 (2008-02-21) * paragraphs [0078] - [0114]; figures 1-3 * ----- | 1,2,4-7, 9-14 | |

TECHNICAL FIELDS
SEARCHED     (IPC)

G02B

The present search report has been drawn up for all claims

| Place of search | Date of completion of the search | Examiner |
|---|---|---|
| Munich | 14 June 2018 | Wolf, Steffen |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

................................................................
& : member of the same patent family, corresponding
     document

EPO FORM 1503 03.82 (P04C01)

## ANNEX TO THE EUROPEAN SEARCH REPORT
## ON EUROPEAN PATENT APPLICATION NO.

EP 17 30 6763

This annex lists the patent family members relating to the patent documents cited in the above-mentioned European search report.
The members are as contained in the European Patent Office EDP file on
The European Patent Office is in no way liable for these particulars which are merely given for the purpose of information.

14-06-2018

| Patent document cited in search report | | Publication date | Patent family member(s) | | Publication date |
|---|---|---|---|---|---|
| US 9442227 | B2 | 13-09-2016 | US | 2014198380 A1 | 17-07-2014 |
| | | | WO | 2013005231 A2 | 10-01-2013 |
| US 2008043334 | A1 | 21-02-2008 | US | 2008043334 A1 | 21-02-2008 |
| | | | WO | 2008020450 A2 | 21-02-2008 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2017180403 A
- US 2012127577 A
- US 9019615 B
- US 20090128911 A